# EUROPEAN PATENT SPECIFICATION

(11) **EP 0 844 677 B1**
(45) Date of publication and mention of the grant of the patent: **13.08.2003**
(21) Application number: 96308464.5
(22) Date of filing: 22.11.1996
(51) Int. Cl.: H01L 39/24

(54) **A novel ceramic substrate for bi-cuprate superconductors and a process for preparing the same**
Neues keramisches Substrat für Bikupratsupraleiter und Verfahren zu dessen Herstellung
Substrat en céramique nouveau supraconducteurs de type bi-cuprate et procédé de fabrication

(43) Date of publication of application: 27.05.1998
(73) Proprietor: Council of Scientific and Industrial Research, New Delhi 110 001 (IN)
(72) Inventor: Koshy, Jacob, Trivandrum-695019 (IN); Kurian, Jose, Trivandrum-695019 (IN); Sajith, Poo Kodan, Trivandrum-695019 (IN); Kumar, Krishnan Sudersan, Trivandrum-695019 (IN); Jose, Rajan, Trivandrum-695019 (IN); John, Mary Asha, Trivandrum-695019 (IN); Damodaran, Alathur Damodaran, Trivandrum-695019 (IN)
(74) Representative: Gaunt, Robert John

(56) References cited:
- PHYSICA C, 10 JAN. 1996, ELSEVIER, NETHERLANDS, vol. 256, no. 3-4, ISSN 0921-4534, pages 312-318, XP002029562 KUMAR K S ET AL: "Superconducting YBCO-Ag (Tc(0)/=92 K) and Bi(2223)-Ag (T/c(0)/=110 K) composite thick films by dip coating on DyBa2SnO5.5, a new perovskite ceramic substrate"
- PHYSICA C, 15 DEC. 1994, NETHERLANDS, vol. 234, no. 3-4, ISSN 0921-4534, pages 211-218, XP002029563 KOSHY J ET AL: "DyBa2SnO5.5 A new ceramic substrate for superconducting YBCO (Tc(o)=92 K) and Bi(2223) (Tc(o)=110 K) thick films"

## Description

### Field of the Invention

The invention relates to a novel ceramic substrate of formula Ba₂DyMO_{5.5} wherein M represents at least one of the metals Zr and Hf, a process for the preparation of said ceramic substrates for Bi-cuparate superconductors, Bi-cuparate superconductors and a process for the preparation of phase pure superconducting Bi(2223) and Bi(2223)-Ag thick films on these newly developed substrates.

### Prior art of the invention

The immediate application of high T_{c} superconductors is likely to be in the form of thick and thin films in electronic devices [Alford N. McN et al., Supercond. Sci. Technol. 4 (1991) 433; Pinto, R. et al., Applied Superconductivity 1 (1993) 1]. In the preparation of superconducting films, substrates play a vital role and the high chemical reactivity of Bi-cuprate superconductors imposes severe restrictions on the materials available for their use as substrates for Bi-cuprate superconductors [McGinnis, W.C. et al. J. Mater. Res. 7 (1992) 585]. Besides for microwave applications, the substrate should have a low dielectric constant and loss factor at Gh_{z} frequencies [Preng, L.H. et al., Supercond. Sci. Technol. 3 (1990) 233]. To the best of our knowledge, MgO is the only substrate suitable for Bi-cuparate films for microwave applications. However, the Bi(Pb)SrCaCuO [BiSCCO] films developed on MgO contained mixed phases of both low T_{c}, Bi(2212) ]T_{c(o)}=80 K] and high Tc, Bi(2223) [T_{c(o)}=110K] (McGinnis, W.C. et al., j. Mater. Res. 7 (1992) 585; Agarwal, A. et al., Supercond. Sci. Technol. 6 (1993) 670]. Other commercially available substrates such as Si, SiO₂, Al₂O₃ and SrTiO₃ etc. are either chemically reactive with BiSCCO superconductor or have high dielectric constant and loss factor which makes superconductor or have high dielectric constant and loss factor which makes them unsuitable or less attractive for microwave applications.

PHYSICA C, 15 DEC. 1994, NETHERLANDS, vol. 234, no. 3-4, ISSN 0921-4534, pages 211-218, XP002029563 KOSHY J et al discloses that a new perovskite ceramic material, DyBa₂SnO_{5.5}, has been synthesised and sintered as single-phase material for its use as a substrate for both YBCO and BiSCCO superconductors.

PHYSICA C, 10 JAN. 1996, ELSEVIER, NETHERLANDS, vol. 256, no. 3-4, ISSN 0921-4534, pages 312-318, XP002029562 KUMAR K S et al describes superconducting YBCO-Ag and Bi(2223)-Ag composite thick films fabricated on polycrystalline DyBa₂SnO_{5.5} by dip coating.

We have now developed new substrate materials, Ba₂DyMO_{5.5} (M = Zr and Hf) which are found to be non-reacting with BiSCCO superconductor even at extreme processing conditions and have low dielectric constant and loss factors. We have produced phase pure Bi(2223) and Bi(2223) - Ag thick films with Tc₍ₒ₎ =110K and high critical current density (-10⁴ A/cm²) on these substrates.

### Objects of the invention

Thus, the main objective of the present invention is to provide ceramic substrates of Ba₂DyMO_{5.5} (M=Zr, and Hf), a process for the preparation of said ceramic substrates, Bi-cuparate superconductors and a process for the preparation of single phase Bi(2223) and Bi(2223)-Ag thick films of Tc_{(O)} =110K and high critical current density on these substrates.

To meet these objectives, the present invention provides a novel ceramic substrate of formula Ba₂DyMO_{5.5}, a process for the preparation of superconducting Bi(2223) and Bi(2223)-Ag thick films on the new substrate and the superconductor produced by the process.

Accordingly, one embodiment of the present invention relates to a process for producing new ceramic substrates of the formula Ba₂DyMO_{5.5} where M represents metals Zr and Hf, useful for the preparation of superconducting films thereon, which comprises :
(i) mixing salts of dysprosium, barium and Zr and Hf in an organic medium,
(ii) pressing the resultant mixture in the form of pellets,
(iii) calcining the pellets by heating at a temperature in the range of 1000 to 1200°C,
(iv) repeating the calcination process altogether not exceeding for 30 to 45 h, preferably 12 h for each calcination, at temperature in the range of 1000 to 1200°C till a highly homogeneous mixture is formed,
(v) grinding the calcined material and pelletising at a pressure in the range of 3 to 4 tonns/cm², and
(vi) sintering the resultant product at a temperature in the range of 1200 to 1600°C for a period of 10 to 30 h preferably 20 h and then furnace cooled to room temperature.

The salts of dysprosium, barium and other metals used may be selected from oxides, carbonates or nitrates. The purity of the salts may be of 99.9%. The organic medium used may be selected from organic solvents such as acetone, ethyl alcohol, isopropyl alcohol. Multiple calcinations (preferably three times) of the pellets may be conducted at temperature 1000 to 1200°C for a period ranging from 10 to 15 h preferably 12 h for each calcination. The sintering of the final product may be effected for a period of 10 to 30 h preferably for 20 h.

In view of the suitability of Ba₂DyMO_{5.5} substrates, we have successfully screen-printed/dip-coated thick films of Bi(2223) and Bi(2223)-Ag with a zero resistivity superconducting transition at 110 K on these substrates.

Thus, yet another aspect of the present invention relates to a process for the preparation of superconducting Bi(2223) and Bi(2223)-Ag thick films on new ceramic substrates of the formula Ba₂DyMO_{5.5} where M represents metals namely Zr and Hf, useful for the preparation of superconducting films, which comprises:
(i) Mechanically polishing the ceramic substrate of the above said formula to get highly smooth and shining surfaces,
(ii) Preparing thick films of Bi(2223) and Bi(2223)-Ag composites with 5-10 Vol% of Ag by known methods,
(iii) (a) Screen printing Bi(2223) and Bi(2223)-Ag on said polished Ba₂DyMO_{5.5} substrates using a mesh size in the range of 325, or (b) Dip-coating Bi(2223) and Bi(2223)-Ag on said polished Ba₂DyMO_{5.5} using a suspension of the respective powder with an organic solvent,
(iv) Drying the resultant films at a temperature in the range of 100 to 150°C,
(v) Heating the dried films at a rate of 200 to 300°C/h upto 860-880°C and soaking at this temperature for 1 to 5 minutes,
(vi) Cooling the film at a rate of 10°C/h to bring down the temperature to 845°C and keeping the films at this temperature for a period of 2-4 h, and
(vii) Cooling the film at a rate of 200°C/h upto room temperature.

All the above steps are being carried out in the presence of air or oxygen.

The details of the invention are described in Example 1 given below and which is provided by way of illustration only and should not be constructed to limit the scope of the invention. Examples 2, 3, 4 and 5 provide technological background.

### Example 1

### Preparation of ceramic substrates of the formula Ba₂DyZrO_{5.5}

Ba₂DyZrO_{5.5} was prepared by solid state reaction method . Dy₂O₃, BaCO₃ and ZrO₂ (purity 99.9%) were taken in stoichiometric ratio, mixed thoroughly in acetone medium and calcined in air at 1150°C for 45 h with two intermediate grindings. The resultant mixture was powdered and pressed at a pressure of 5 tons/cm², in the form of circular pellets and sintered in air at 1450° C for 20 h.

### Example 2

### Preparation of ceramic substrate of the formula Ba₂DySnO_{5.5}

Ba₂DySnO_{5.5} was prepared by solid state reaction method . Dy₂O₃, BaCO₃ and SnO₂ (purity 99.9%) were taken in stoichiometric ratio, mixed thoroughly in acetone and calcined in air at 1100°C h with two intermediate grindings. The resultant mixture was powdered and pressed at a pressure of 4 tons/cm² in the form of circular pellets and sintered in air at 1360°C for 20 h.

### Structural determination

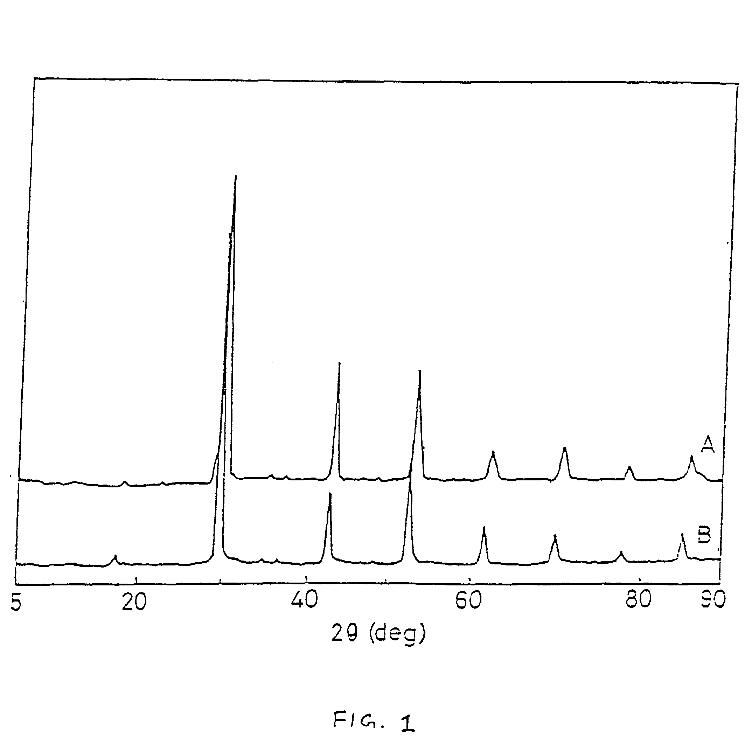

The structure of the sintered material was examined by X-ray diffraction (XRD) method and it is found that all these materials are isostructural having a cubic perovskite structure as shown in the XRD patterns in fig 1(sheet No.1) of the drawings accompanying this specification for two typical samples Ba₂DyZrO_{5.5} (Example 1) and Ba₂DySnO_{5.5} (Example 2) . In table la and b, we have given the computerised XRD data for these materials .

### Dielectric properties

The dielectric properties of the substrate materials were measured in the range 30 Hz to 13MHz frequencies and values of the dielectric constant (ε') and loss factor (tan δ) at 13 MHz, frequency are 12 and 10-³ respectively at room temperature. At GHz frequencies the values of ε' and tan δ are found to be 10 and 10-⁵ respectively, which are ideally suitable for microwave applications.

### Chemical compatibility of Ba₂DyMO_{5.5} with Bi(2223) superconductor

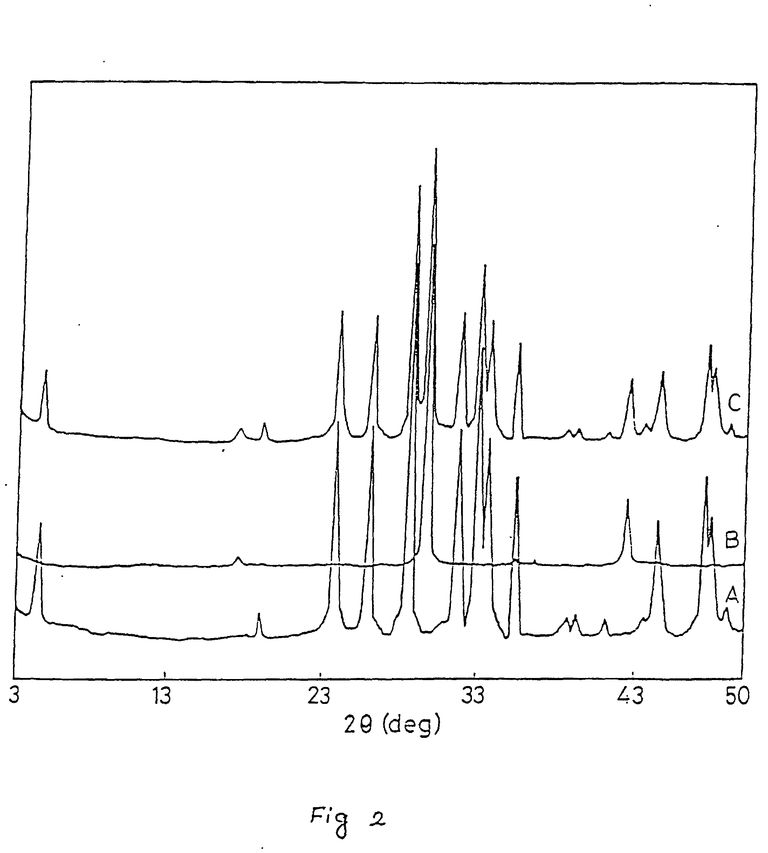

The most important characteristics of a material to be used as a substrate for superconductors is its chemical non-reactivity with the superconductor at the processing temperature. The chemical reactivity between Ba2DyMO_{5.5} and Bi(2223) was studied by mixing 1:1 vol% of Ba₂DyMO_{5.5} and Bi(2223 ) and annealing the present pellet at 850°C for 20 h . The XRD pattern of the annealed 1:1 vol% mixture of Ba₂DySnO_{5.5} and Bi(2223) is shown in fig.2 (sheet No.2) . The XRD pattern in the two phases in fig.2c is compared with those of pure Bi(2223) (fig.2a) and pure Ba₂DySnO_{5.5}(fig. 2b). fig.2 shows that there is no additional phase formed, not even Bi(2212) in the annealed composite sample other than those of Bi(2223) and Ba₂DySnO_{5.5}. This clearly indicates that there is no chemical reaction between Ba₂DySnO_{5.5} and Bi(2223), even at the extreme processing conditions. Detailed percolation studies carried on Ba₂DySnO5 Bi(2223) composites confirmed that the Bi(2223) and Ba₂DySnO_{5.5} are found to remain as separated phases with their own charateristic even under severe heat treatment suggesting that Ba₂DySnO_{5.5} can be ideal substrate material for Bi(2223). Ba₂DySnO_{5.5} are insulating peovskite oxides with resistivity of the order of 10 ohm.cm . In view of the suitability of Ba₂DySnO_{5.5} substrates, we have successfully screen-printed/dip-coated thick films of Bi(2223) and Bi(2223)-Ag with Tc₍ₒ₎=110 K on these substrates.

The present process for fabrication of Bi(2223) and Bi(2223)-Ag by screen printing/dip coating thick films on Ba₂DySnO_{5.5} substrates is given below :

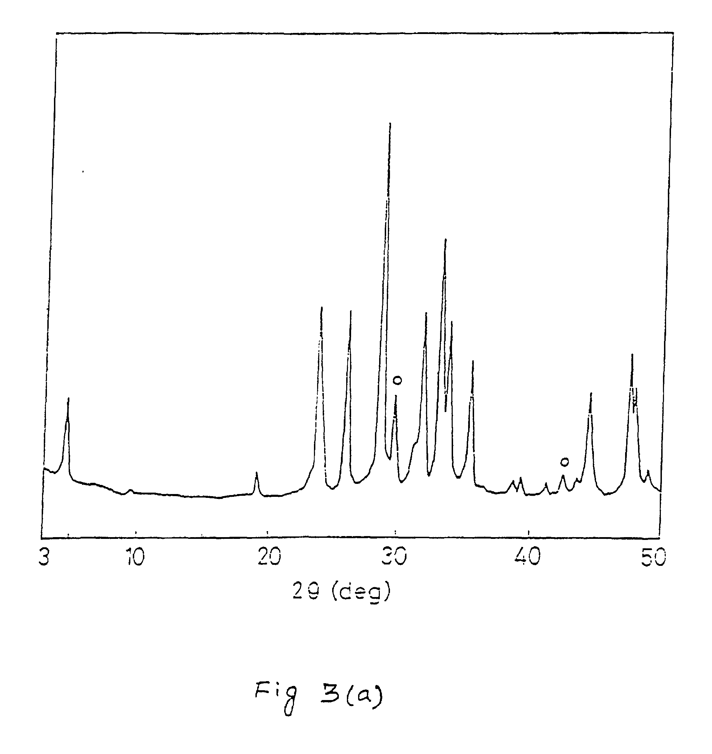

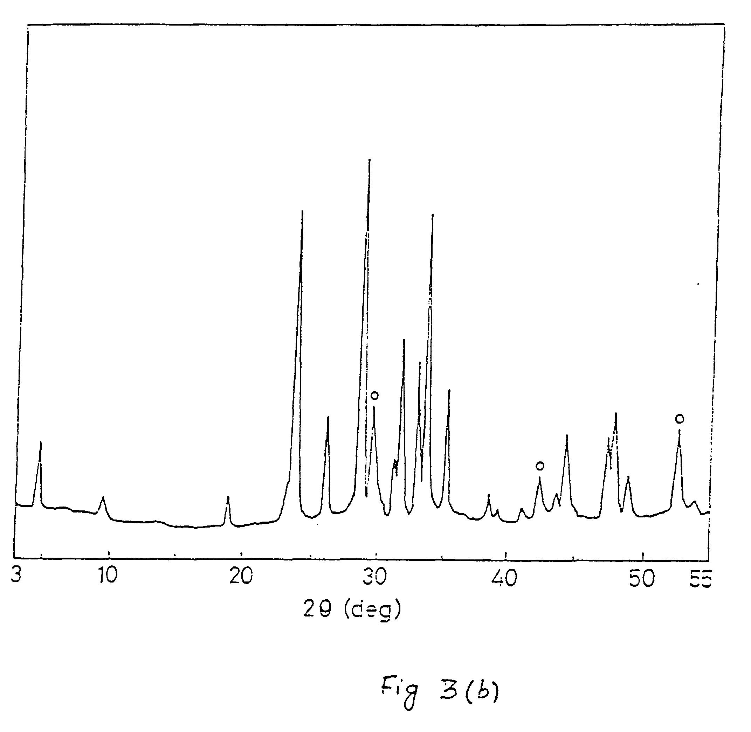

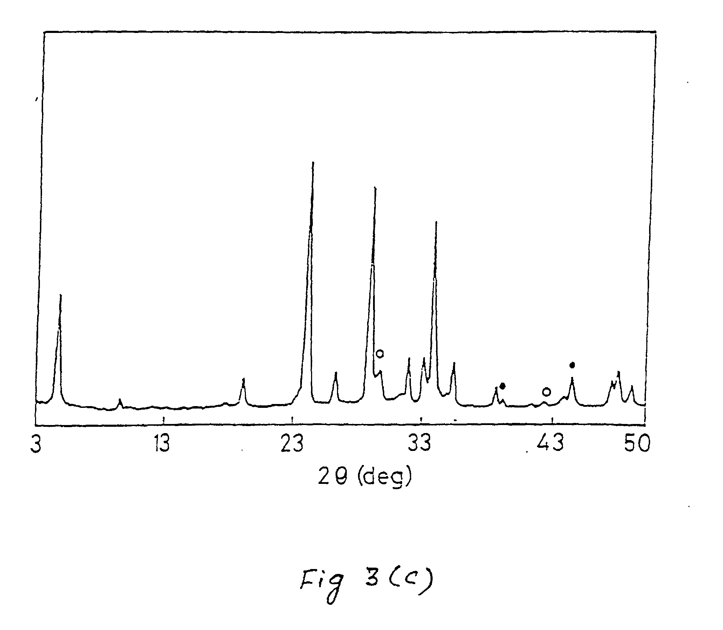

Before screen-printing/dip-coating Bi(2223) and Bi(2223)-Ag, Ba₂DySnO_{5.5} substrates were mechanically polished to get highly smooth and shining surfaces. For screen printing thick film paste of Bi(2223) and Bi(2223)-Ag were made by mixing respective powder with an organic vehicle. Film thickness was controlled via viscosity control of the thick film paste. This thick film paste was then screenprinted on Ba₂DySnO_{5.5} substrates using a mesh size of 325. In the case of dip-coating the suspension of Bi(2223) and Bi(223)-Ag were prepared by mixing their respective fine powders separately in an organic medium and the viscosities were controlled by the addition of commercially available fish oil. Thick films of Bi(2223) and Bi(2223)-Ag were prepared by dipping polished Ba₂DySnO_{5.5} substrates into respective suspension. screen printed/dip-coated films were dried at 100 ° to 150 °C for 2 to 3 h. Dried films were heated in a programmable furnace at a rate of 200° to 300°C h upto 860-880°C and soaked at this temperature for 11-5 min. The films were cooled down at a rate of 10°C/h and brought down to 845°c and kept at this temperature for 2-4 h and films were then cooled down to room temperature at a rate of 200°C . All the above processes were done in air. The structure of the films were examined by X-ray diffraction method and XRD patterns of these typical thick films of Bi(2223) on Ba₂DySnO_{5.5} are shown in Fig.3 (given on sheet Nos. 3,4&5). The XRD patterns of these(2223) thick films showed that except for the characteristic peaks of Ba₂DySnO_{5.5} substrates, all other peaks could be assigned to a phase pure Bi(2223) superconductor .

The following examples illustrate the preparation of superconducting film employing the substrates.

### Example 3

### Preparation of superconducting Bi(2223) thick film on ceramic substrate of formula Ba₂DySnO_{5.5}

Highly polished polycrystalline Ba₂DySnO_{5.5} substrate was used for the fabrication of Bi(2223) thick films. Thick films paste of Bi(2223) was prepared by mixing Bi(2223) with n-butanol. The viscosity of the paste was controlled by the addition of commercially available fish oil. This paste was then screen printed on Ba₂DySnO_{5.5} substrate using a screen of 325 mesh size. The printed film was then dried in an oven at 200°C for 3 h. The film was then heated in a programmable furnace in air at a rate of 200°C/h upto 880°C and was kept at this temperature for two minutes . It was then cooled at a rate of 10°C/h upto 845°C and kept at this temperature for 3 h and finally furnace cooled to room temperature.

### Example 4

### Preparation of superconducting Bi(2223) thick film on ceramic substrate of formula Ba₂DySnO_{5.5}

The thick film suspension of Bi(2223) for dip-coating was prepared by mixing fine powder of Bi(2223) with n-butanol and the viscosity was controlled by the addition of fish oil. The thick film of Bi(2223) was prepared by dipping highly polished Ba₂DySnO_{5.5} substrate in the Bi(2223) suspension . The film is then dried in an electric oven at 150°C for 3 h. The dried film was then heated in a programmable furnace at a rate of 200°C/h upto 880°C and kept at this temperature for 3 min. The film was then cooled down upto 845°C at a rate of 10°C/h and kept at this temperature for 3 h. It was then cooled at a rate of 200°C /h to room temperature. The entire process was carried out in air.

### Example 5

### Preparation of superconducting Bi(2223)-Ag thick film on ceramic substrate of formula Ba₂DySnO_{5.5}

Thick film suspension of Bi(2223)-Ag for dip-coating was made by mixing superconducting Bi(2223)-Ag composite powder with n-butanol . Thick film of Bi(2223)
-Ag composite having 7 vol% of Ag was fabricated by dipping highly polished Ba₂DySnO_{5.5} substrate in this suspension . The coated film was kept in an electric oven at 200°C for 3 h, to remove the organic solvent present in the film. The film was then heated in a programmable furnace in air at a rate of 300°C/h upto 870°C and kept at this temperature for 2 min and cooled at a rate of 10°C/h upto 845°C and kept at this temperature for 3 h. The film was then cooled at room temperature.

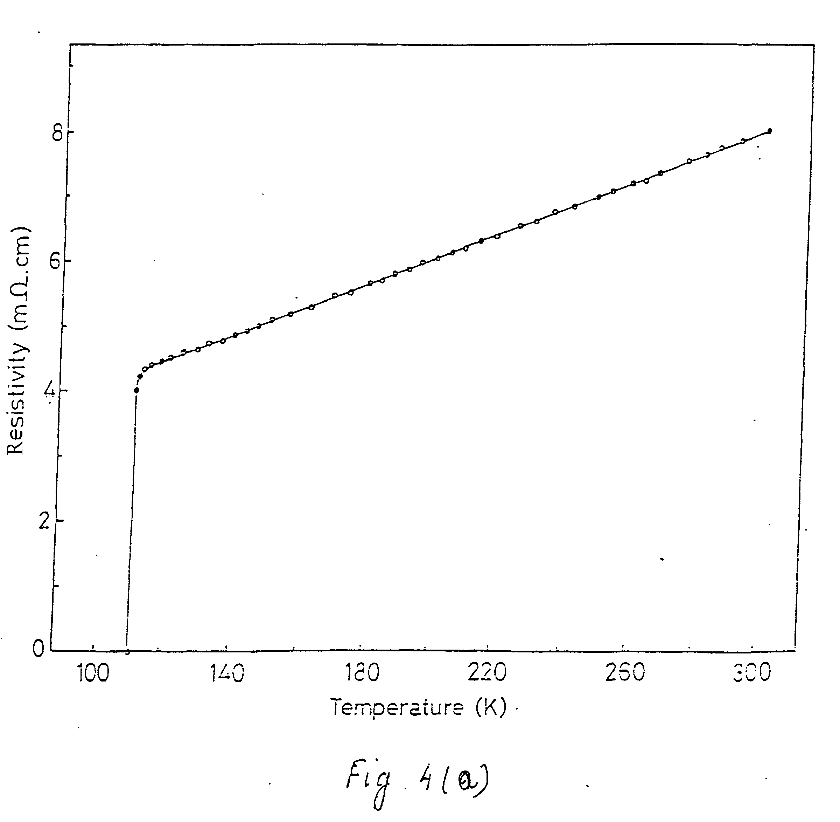

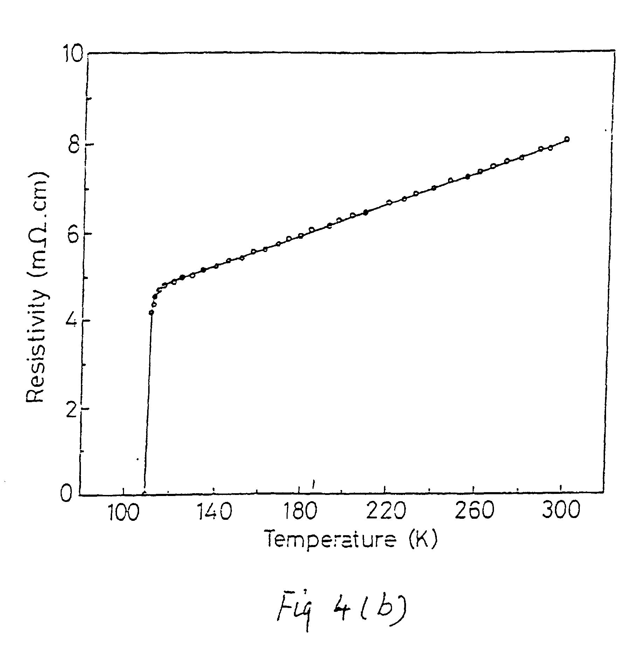

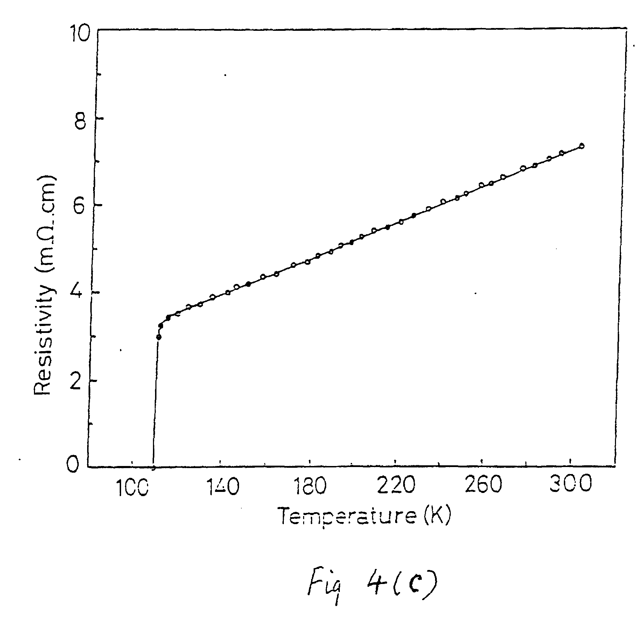

The structure of the film was examined by X-ray diffraction technique. The XRD patterns of three typical thick films on Ba₂DySnO_{5.5} (example 3). Ba₂DySnO_{5.5} (example 4) and Ba₂DySnO_{5.5} (example 5) substrates are shown in Fig.3(a), (b) & (c) of the drawings (sheet Nos. 3,4 & 5) accompanying this specification. The XRD pattern of these Bi(2223) thick films showed that except for the characteristic peaks of Ba₂DySnO_{5.5} substrates, all other peaks could be assigned to a phase pure Bi (2223) superconductor. Superconductor in these Bi(2223) thick films on Ba₂DySnO_{5.5} substrates were studied by temperature-resistance measurements shown in Fig.4 (sheet No.6,7 & 8). The films show a metallic behavior in the normal state and give zero resistivity superconducting transition at 110 k.

**Table 1(a) :**

| X-ray diffraction data of Ba₂DyZrO_{5.5} | | | | |
|---|---|---|---|---|
| No. | 2θ | d | l/lₒ | hkl |
| 1 | 29.830 | 2.993 | 100 | 220 |
| 2 | 35.360 | 2.545 | 10 | 311 |
| 3 | 42.920 | 2.105 | 53 | 400 |
| 4 | 48.380 | 1.880 | 15 | 420 |
| 5 | 53.140 | 1.722 | 51 | 422 |
| 6 | 62.170 | 1.492 | 22 | 440 |
| 7 | 70.460 | 1.335 | 23 | 620 |
| 8 | 78.680 | 1.215 | 15 | 444 |
| 9 | 85.720 | 1.132 | 20 | 642 |

**Table 1(b):**

| X-ray diffraction data of Ba₂DySnO_{5.5} | | | | |
|---|---|---|---|---|
| No. | 2 θ | d | l/lₒ | hkl |
| 1 | 17.480 | 5.069 | 9 | 111 |
| 2 | 29.720 | 3.004 | 100 | 220 |
| 3 | 34.900 | 2.569 | 7 | 311 |
| 4 | 36.560 | 2.456 | 7 | 222 |
| 5 | 42.530 | 2.124 | 25 | 400 |
| 6 | 52.690 | 1.736 | 32 | 422 |
| 7 | 61.660 | 1.503 | 15 | 440 |
| 8 | 69.930 | 1.344 | 13 | 620 |
| 9 | 77.650 | 1.229 | 9 | 444 |
| 10 | 85.470 | 1.135 | 12 | 642 |

## Claims

1. A ceramic substrate useful for the preparation of superconductors, said substrate having the formula Ba₂DyMO_{5.5} where M represents at least one of the metals Zr and Hf.

2. A process for the preparation of ceramic substrates useful for the preparation of superconducting Bi-cuprate films, said substrate having the formula Ba₂DyMO_{5.5} where M represents at least one of the metals Zr and Hf, which comprises:
(i) Reacting salts of dysprosium, barium and Zr or Hf in an organic medium,
(ii) Pressing the resultant mixture in the form of pellets,
(iii) Calcining the pellets by heating at a temperature in the range of 1000 to 1200 °C,
(iv) Repeating the calcination process for 30-45 h, preferably 12 h for each calcination, at temperature in the range of 1000- 1200°C until a highly homogenous mixture is formed,
(v) Grinding the calcined material and pelletising at a pressure in the range of 3 to 4 tons/cm², and
(vi) Sintering the resultant product at a temperature in the range of 1200 to 1600°C for a period of 10 to 30 h, and then furnace cooled to room temperature.

3. A process as claimed in claim 2 wherein the salts of dysprosium, barium and other metals used are selected from oxides, carbonates or nitrates and the like.

4. A process as claimed in claim 2 wherein the purity of the salts is about 99.9%.

5. A process as claimed in claim 2 wherein the organic medium used is an organic solvent such as acetone, alcohol or the like.

6. A process as claimed in claim 2 wherein the multiple calcination of the pellets is effected for a period ranging from 30 to 45 h, preferably 12 h, for each calcination.

7. A process as claimed in claim 2 where in the sintering of the final product is effected for a period of 10 to 30 h, preferably for 20 h.

8. Bi-cuprate superconductor comprising a ceramic substrate having the formula Ba₂DyMO_{5.5} where M represents at least one of the metals Zr and Hf, which is coated with at least one layer of superconducting Bi(2223) and Bi(2223)-Ag thick film.

9. A process for the preparation of superconducting Bi(2223) and Bi(2223)-Ag thick films on a ceramic substrate as defined in claim 1, said process comprising:
(i) Mechanically polishing the ceramic substrate to give a highly smooth and shining surface,
(ii) Preparing a thick film of Bi(2223) and Bi(2223)-Ag composites having Ag 5 vol% by known methods,
(iii)(a) screen-printing Bi (2223) and Bi (2223)-Ag on the substrate using a mesh size in the range of 325, or
(iii)(b)Dip-coating Bi(2223) and Bi(2223)-Ag on the substrate using suspensions of respective powders with organic solvents,
(iv) Drying the resulting film at a temperature in the range of 100 to 150°C,
(v) Heating the dried film at a rate of 200 to 300°C/h upto 860-880°C and soaking at this temperature for 1 to 5 minutes,
(vi) Cooling the film at a rate 10°C/h to bring down the temperature to 845°C and keeping the film at this temperature for a period of between 2 and 4 h, and
(vii) Cooling the film at a rate of 200°C/h to room temperature,
all of the above steps being carried out in the presence of air or oxygen.

## Patentansprüche

1. Ein keramisches Substrat, geeignet zur Herstellung von Supraleitern, wobei das Substrat die Formel Ba₂DyMO_{5,5} aufweist, wobei M für mindestens eines der Metalle Zr und Hf steht.

2. Ein Verfahren zur Herstellung eines keramischen Substrates, geeignet zur Herstellung von supraleitfähigen Bikuprat-Schichten, wobei das Substrat die Formel Ba₂DyMO_{5,5} aufweist, wobei M für mindestens eines der Metalle Zr und Hf steht, wobei das Verfahren folgendes umfaßt:
(i) Reagieren von Dysprosium-, Barium- und Zr- oder Hf-Salzen in einem organischen Medium,
(ii) Pressen der resultierenden Mischung in die Form von Pellets,
(iii) Kalzinieren der Pellets durch Erhitzen bei einer Temperatur im Bereich von 1000 bis 1200°C,
(iv) Wiederholen des Kalzinierungsprozesses für 30-45 Stunden, vorzugsweise 12 Stunden für jede Kalzinierung, bei einer Temperatur im Bereich von 1000 - 1200°C, bis eine hoch homogene Mischung gebildet ist,
(v) Mahlen des kalzinierten Materials und Pelletisieren bei einem Druck im Bereich von 3 bis 4 Tonnen/cm², und
(vi) Sintem des resultierenden Produktes bei einer Temperatur im Bereich von 1200 bis 1600°C für einen Zeitraum von 10 bis 30 Stunden, und dann ofenabgekühlt auf Raumtemperatur.

3. Ein Verfahren nach Anspruch 2, wobei die Dysprosium- und Bariumsalze und die Salze der andere verwendeten Metalle aus Oxiden, Carbonaten oder Nitraten und ähnlichen gewählt werden.

4. Ein Verfahren nach Anspruch 2, wobei die Reinheit der Salze ungefähr 99,9 % beträgt.

5. Ein Verfahren nach Anspruch 2, wobei das verwendete organische Medium ein organisches Lösungsmittel wie Aceton, Alkohol oder ähnliches ist.

6. Ein Verfahren nach Anspruch 2, wobei die mehrfache Kalzinierung der Pellets über einen Bereich von 30 bis 45 Stunden, vorzugsweise 12 Stunden für jede Kalzinierung, bewirkt wird.

7. Ein Verfahren nach Anspruch 2, wobei das Sintern des endgültigen Produktes für einen Zeitraum von 10 bis 30 Stunden, vorzugsweise für 20 Stunden, bewirkt wird.

8. Bikuprat-Supraleiter, umfassend ein keramisches Substrat mit der Formel Ba₂DyMO_{5,5}, wobei M für mindestens eines der Metalle Zr und Hf steht, der mit mindestens einer Schicht supraleitendem Dickfilm-Bi(2223) und -Bi(2223)-Ag beschichtet ist.

9. Ein Verfahren zur Herstellung von supraleitenden Bi(2223) und Bi(2223)-Ag-Dickfilmen auf einem keramischen Substrat, wie in Anspruch 8 definiert, wobei das Verfahren folgendes umfaßt:
(i) Mechanisches Polieren des keramischen Substrats, um eine hoch glatte und glänzende Oberfläche zu ergeben,
(ii) Herstellen eines Dickfilms von Bi(2223)- und Bi(2223)-Ag-Schichtkörpern mit 5 Vol.-% Ag nach bekannten Verfahren.
(iii)
(a) Rasterdrucken von Bi (2223) und Bi(2223)-Ag auf das Substrat unter Verwendung einer Maschenweite im Bereich von 325, oder
(b) Tauchbeschichten von Bi (2223) und Bi(2223)-Ag auf das Substrat unter Verwendung von Suspensionen von entsprechenden Pulvern mit organischen Lösungsmitteln,
(iv) Trocknen des resultierenden Films bei einer Temperatur im Bereich von 100 bis 150°C,
(v) Erhitzen des getrockneten Films in einer Rate von 200 bis 300°C/h bis auf 860-880°C und Halten auf dieser Temperatur für 1 bis 5 Minuten,
(vi) Kühlen des Films in einer Rate von 10°C/h, um die Temperatur auf 845°C abzusenken und Halten des Films bei dieser Temperatur für eine Dauer zwischen 2 und 4 Stunden, und
(vii) Kühlen des Films in einer Rate von 200°C/h auf Raumtemperatur,
wobei alle obigen Schritte in Gegenwart von Luft oder Sauerstoff durchgeführt werden.

## Revendications

1. Substrat en céramique, utile pour la préparation de supraconducteurs, ledit substrat répondant à la formule Ba₂DyMO_{5,5} où M représente au moins l'un des métaux Zr et Hf.

2. Procédé pour la préparation de substrats en céramique utiles pour la préparation de films de cuprate de Bi supraconducteurs, lesdits substrats répondant à la formule Ba₂DyMO_{5,5} où M représente au moins l'un des métaux Zr et Hf, qui comprend :
(i) la réaction de sels de dysprosium, de baryum et de Zr ou de Hf dans un milieu organique,
(ii) le pressage du mélange résultant sous la forme de pastilles,
(iii) la calcination des pastilles par chauffage à une température située dans la plage allant de 1000 à 1200°C,
(iv) la répétition du processus de calcination pendant 30-45 heures, de préférence 12 heures, pour chaque calcination, à une température située dans la plage allant de 1000 à 1200°C jusqu'à ce qu'un mélange très homogène soit formé,
(v) le broyage du matériau calciné et sa mise sous forme de pastilles, à une pression située dans la plage allant de 3 à 4 tonnes/cm², et
(vi) le frittage du produit résultant à une température située dans la plage allant de 1200 à 1600°C pendant une période de 10 à 30 heures, et ensuite le refroidissement en four jusqu'à la température ambiante.

3. Procédé selon la revendication 2, dans lequel les sels de dysprosium, baryum et autres métaux utilisés sont choisis parmi les oxydes, les carbonates et les nitrates et analogues.

4. Procédé selon la revendication 2, dans lequel la pureté des sels est d'environ 99,9 %.

5. Procédé selon la revendication 2, dans lequel le milieu organique utilisé est un solvant organique tel que l'acétone, un alcool ou analogue.

6. Procédé selon la revendication 2, dans lequel la calcination multiple des pastilles est effectuée pendant une période située dans la plage allant de 30 à 45 heures, de préférence 12 heures, pour chaque calcination.

7. Procédé selon la revendication 2, dans lequel le frittage du produit final est effectué pendant une période de 10 à 30 heures, de préférence pendant 20 heures.

8. Supraconducteur de type cuprate de Bi comprenant un substrat en céramique répondant à la formule Ba₂DyMO_{5,5} où M représente au moins l'un des métaux Zr et Hf, qui est revêtu d'au moins une couche de film épais de Bi(2223) et Bi(2223)-Ag supraconducteur.

9. Procédé pour la préparation de films épais de Bi(2223) et Bi(2223)-Ag supraconducteurs sur un substrat en céramique tel que défini dans la revendication 8, ledit procédé comprenant :
(i) le polissage mécanique du substrat en céramique pour donner une surface très lisse et brillante,
(ii) la préparation d'un film épais de composites de Bi(2223) et Bi(2223)-Ag ayant une teneur en Ag de 5 % en volume par des procédés connus,
(iii)
(a) l'application par sérigraphie de Bi(2223) et de Bi(2223)-Ag sur le substrat en utilisant une ouverture de maille de 325 (0,037 mm), ou
(b) l'application en revêtement par immersion de Bi(2223) et de Bi(2223)-Ag sur le substrat en utilisant des suspensions de poudres respectives avec des solvants organiques,
(iv) séchage du film résultant à une température située dans la plage de 100 à 150°C,
(v) chauffage du film séché à raison de 200 à 300°C/h jusqu'à 860-880°C et maintien à cette température pendant 1 à 5 minutes,
(vi) refroidissement du film à raison de 10°C/h pour abaisser la température à 845°C et maintien du film à cette température pendant 2 à 4 h, et
(vii) refroidissement du film à raison de 200°C/h jusqu'à température ambiante,
toutes les étapes ci-dessus étant effectuées en présence d'air ou d'oxygène.
